# EUROPEAN PATENT APPLICATION

(11) **EP 4 712 261 A1**
(43) Date of publication of application: **18.03.2026**
(21) Application number: 25200919.6
(22) Date of filing: 08.09.2025
(51) Int. Cl.: H01Q 1/22, H01Q 21/00, H01Q 9/04, H10W 44/20

(54) **ANTENNA FOR MM-WAVE SIGNAL TRANSMISSION**

(30) Priority: 13.09.2024 US 202418884278
(71) Applicant: NXP B.V., 5656 AG Eindhoven (NL)
(72) Inventor: ACAR, Mustafa, 5656AG Eindhoven (NL); MANDAMPARAMBIL, Rajesh, 5656AG Eindhoven (NL); VAN DER HEIJDEN, Mark Pieter, 5656AG Eindhoven (NL)
(74) Representative: Hardingham, Christopher Mark

(57) **Abstract**

An electronic device realizes an antenna-in-package (AiP). The device includes a first die having a first metal layer that defines an antenna patch, a second metal layer that defines a parasitic patch above and vertically aligned with the antenna patch, and an amplifier having an output terminal electrically coupled to the antenna patch. The device further includes a second die having a metal layer that defines a reflecting patch and an interconnect that joins the first die with the second die in a vertical stack with the first die above the second die such that the antenna patch is spaced apart from, parallel to, and vertically aligned with the reflecting patch.

## Description

### BACKGROUND

This disclosure relates generally to RF (radio frequency) and microwave circuits, devices, and methods, and more particularly to techniques for incorporating antennas into semiconductor dies and/or packages.

Antenna-in-Package (AiP) solutions are common constituents of many RF and microwave technologies, such as radar systems and wireless communications. One prior AiP solution includes an assembly of semiconductor dies, such as a bottom die containing digital circuitry, a middle die containing analog circuitry, and a top die containing RF circuitry. The three dies are arranged in a vertical stack, with a high-frequency signal generated in the bottom die and transmitted a via coaxial TSV (through substrate via) to an upper surface of the top die. An antenna provided at the upper surface of the top die (e.g., as a conductive patch on a laminate above the top die) is electrically connected to the center conductor of the coaxial TSV. Signals generated by the bottom die can thereby be transmitted via the antenna on the top die.

### BRIEF DESCRIPTION OF THE SEVERAL VIEWS OF THE DRAWINGS

The foregoing and other features and advantages will be apparent from the following description of particular embodiments, as illustrated in the accompanying drawings, in which like reference characters refer to the same or similar parts throughout the different views. The drawings are not necessarily to scale, emphasis instead being placed upon illustrating the principles of various embodiments.
FIG. 1 is a cross-sectional view of an example electronic device having an antenna according to one or more embodiments.
FIG. 2 is a top plan view of the electronic device of FIG. 1 with upper layers removed to reveal a parasitic patch of the antenna and a conductive shield, according to one or more embodiments.
FIG. 3 is a bottom plan view of an example first semiconductor die of the electronic device of FIG. 1, according to one or more embodiments.
FIG. 4 is a cross-sectional view of an example electronic device having an air gap disposed between first and second parasitic patches of an antenna, according to one or more embodiments.
FIG. 5 is a cross-sectional view of an example electronic device having solder balls disposed between first and second parasitic patches of an antenna, according to one or more embodiments.
FIG. 6 is a cross-sectional view of an electronic device having multiple antennas according to one or more embodiments.
FIG. 7 is a flowchart showing an example method of making an electronic device having an antenna according to one or more embodiments.
FIG. 8 is a sequence of cross-sectional views showing example steps of making an electronic device having an antenna, according to one or more embodiments.
FIG. 9 is a sequence of cross-sectional views showing example alternative steps of making an electronic device having an antenna with an air gap, according to one or more embodiments.
FIG. 10 is a sequence of cross-sectional views showing example alternative steps of making an electronic device having an antenna with an air gap and with solder balls disposed between first and second parasitic patches, according to one or more embodiments.

### DETAILED DESCRIPTION

The above-described AiP solution may not be optimal for certain applications. For example, signals generated in the bottom die can incur losses when transmitted through coaxial TSVs to the antenna on the top die, particularly at frequencies above 100 GHz (gigahertz), resulting in wasted energy and reduced power output from the antenna. Further, the above-described AiP solution has greater height requirements than is optimal for certain applications, such as mobile devices. For instance, it may be desirable for a high-frequency antenna to include one or more parasitic patches above the antenna to extend its bandwidth. But given that the antenna already sits above the top die in the stack, any parasitic patches would be placed above the antenna, increasing the height of the overall assembly and making it unsuitable for certain compact designs. What is needed, therefore, is an AiP solution that reduces losses and height requirements.

The above need is addressed at least in part by an improved technique of providing an AiP solution. According to one or more embodiments, the technique includes an antenna patch on a first metal layer of a semiconductor die and a parasitic patch on a second metal layer of the same semiconductor die. The parasitic patch is parallel to, vertically aligned with, and spaced apart from the antenna patch. In some embodiments, the antenna patch is coupled to a first surface of the semiconductor die, and the parasitic patch is coupled to a second and opposite surface of the semiconductor die. An amplifier within the semiconductor die is configured to drive the antenna patch.

In some examples, a conductive shield is coupled to the second surface of the semiconductor die and at least partially surrounds the parasitic patch. The conductive shield may be taller than the parasitic patch to provide lateral shielding. In some examples, an insulating layer is disposed above the parasitic patch and a second parasitic patch is disposed upon the insulating layer. In some arrangements, the second surface of the semiconductor die, the second metal layer, the conductive shield, and the insulating layer define an air gap between the two parasitic patches.

According to one or more embodiments, the semiconductor die is a first die and the technique further includes a second die. The first die is disposed above the second die in a vertical stack, and an interconnect is disposed between the two dies to provide electrical connections. In some examples, the second die includes a reflecting patch at its upper surface that is parallel to, vertically aligned with, and spaced apart from the antenna patch. The interconnect has a height that at least partly defines a distance between the antenna patch and the reflecting patch. In some examples, the second die further includes circuitry configured to provide an input signal for driving the amplifier. For example, an output terminal of the circuitry is coupled through the interconnect to an input terminal of the amplifier in the first die.

Advantageously, the improved technique drives the antenna patch with an amplifier formed in the same die, thus avoiding losses normally incurred by coaxial TSVs that transmit high-frequency signals between dies. In addition, the improved technique leverages the geometries of the first die, the second die, and the interconnect to establish desired spacing among the antenna patch, the reflecting patch, and the parasitic patch, and to place antenna structures farther down in the vertical stack than could be achieved in the previous design, enabling the antenna to be realized in a shorter form factor.

Embodiments of the improved technique will now be described. One should appreciate that such embodiments are provided by way of example to illustrate certain features and principles but are not intended to be limiting.

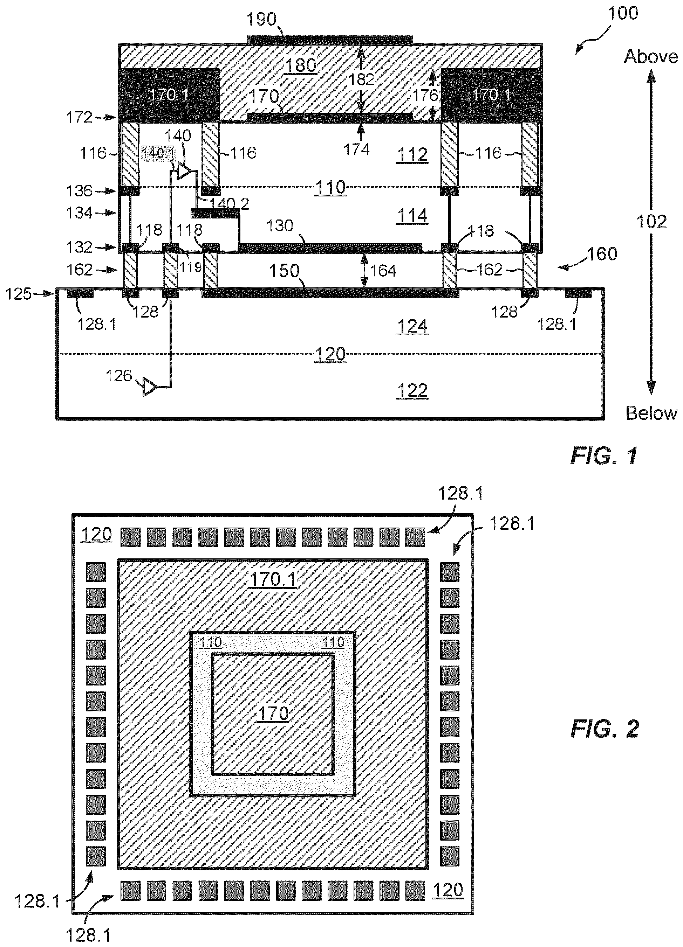

FIG. 1 shows an example electronic device 100 according to one or more embodiments. The device 100 includes a first die 110 and a second die 120. The first die 110 includes a semiconductor substrate 112 and a build-up structure 114, and the second die 120 includes a semiconductor substrate 122 and a build-up structure 124. The outer surface of the build-up structure 114 defines a first surface of the first die 110, and the opposed outer surface of the semiconductor substrate 112 defines a second surface of the first die 110. Similarly, the outer surface of the build-up structure 124 defines a first surface of the second die 120, and the opposed outer surface of the semiconductor substrate 122 defines a second surface of the second die 120. The semiconductor substrates 112 and 122 may be formed, for example, using front-end-of-line (FEOL) processing, and the build-up structures may be formed using back-end-of-line (BEOL) processing, for example.

Preferably, the substrate 112 of the first die 110 is composed of a semiconductor material having low loss and low dielectric constant, such as CMOS SOI (complementary metal oxide semiconductor, silicon-on-insulator), GAN (gallium nitride), or SiGe (silicon-germanium), for example. The substrate 112 may include transistors and other structures, such as an amplifier 140 and TSVs (through substrate vias) 116, which may be realized using doped vertical channels or etched-away regions filled with metal, such as copper. According to one or more embodiments, the TSVs 116 may be "simple" TSVs, which include a vertical conductor that extends through the substrate 112, but which do not include a surrounding ground structure. This simple TSV structure may be contrasted with coaxial TSVs, which include a central conductor and a surrounding ground structure (with insulating material between the central conductor and the surrounding ground structure). The substrate 122 of the second die 120 may be composed of silicon or some other semiconductor material.

The build-up structure 114 in the first die 110 includes patterned metal layers alternating with dielectric, insulating layers. The patterned layers form electrical connections among the circuit elements formed in the substrate 112, with metal vias providing vertical connections between different metal layers. A first metal layer 132 is specifically shown, as well as additional metal layers 134 and 136 of the build-up structure 114. As with the first die 110, the build-up structure 124 of the second die 120 includes patterned metal layers alternating with insulating layers, and the patterned layers (and vias) form electrical connections among circuit elements formed in the substrate 122. One metal layer 125 of the build-up structure 124 is shown.

The device 100 further includes an interconnect 160 that provides electrical connections between the first die 110 and the second die 120. For example, the first metal layer 132 of the first die 110 has electrode pads 118, 119 formed therein. The electrode pads 118, 119 are arranged to align vertically with electrode pads 128 formed in the metal layer 125 of the second die 120 when the two dies 110 and 120 are aligned and arranged face to face, i.e., with the build-up structures 114 and 124 facing each other. The interconnect 160 forms electrical connections between aligned electrode pads 118, 119 and 128 using vertical conductors 162, such as copper pillars, aluminum pillars, solder balls, or the like. The interconnect 160 may be formed, for example, using hybrid bonding or some other form of die-to-die bonding.

To allow for electrical connections between the device 100 and its environment, the metal layer 125 of the second die 120 may include bond pads 128.1. For example, the device 100 may be placed in a package (not shown) and wire bonds may be provided for electrically coupling the bond pads 128.1 to leads or other contacts of the package, thus enabling the device 100 to exchange signals with its environment via the contacts.

According to one or more embodiments, the first die 110 includes a planar, conductive antenna patch 130 on a metal layer of the first die 110. Preferably, the antenna patch 130 is formed as a portion of the first metal layer 132 of the build-up structure 114, i.e., the outermost metal layer, which may be the same layer that includes the electrode pads 118 119. The antenna patch 130 may alternatively be formed on another metal layer, though. In some embodiments, the antenna patch 130 is exposed at the first surface of the first die 110. Typical nomenclature for metal layers of a die refer to the layer 136 that contacts the base substrate 112 the "metal 1" or "M1" layer. It is noted that the term M1 should not be confused with the "first metal layer," which is identified herein by reference 132.

The above-described amplifier 140 has an input terminal 140.1 and an output terminal 140.2. The output terminal 140.2 is electrically coupled to the antenna patch 130 through the build-up structure 114. In an example, the input terminal 140.1 is electrically coupled through the build-up structure 114 and through the interconnect 160 to the output of a circuit 126 in the second die 120, such as a buffer amplifier. In this manner, the second die 120 is configured to generate a low-power, high-frequency signal for driving the amplifier 140, and the amplifier 140 is configured to deliver substantially higher power for driving the antenna patch 130. The amplifier 140 may be arranged as a power amplifier, for example, which includes one or more transistors (e.g., field effect transistors) that are formed in and above the substrate 112.

Preferably, the first die 110 is sparsely filled with, or completely devoid of, electronic components in the region directly above the antenna patch 130 (e.g., in the regions of the substrate 112 and build-up structure 114 between the first and second surfaces of the first die 110). Also, TSVs 116 may be arranged in a via-fence configuration that surrounds the region directly above the antenna patch 130 (e.g., the region of the substrate 112 between the first and second surfaces of the first die 110). Such TSVs may be grounded, i.e., electrically coupled to an electrical node that provides a local ground or system ground. For example, the TSVs 116 may be electrically coupled to respective electrode pads 118 in the first metal layer 132, which in turn may be electrically coupled through the interconnect 160 to one or more ground reference planes within the second die 120. As described above, the TSVs 116 may be "simple" TSVs, as opposed to coaxial TSVs.

The first die 110 and the second die 120 are arranged in a vertical stack 102. A legend shown to the right of FIG. 1 depicts a convention used herein for distinguishing vertical positions of elements. The terms "above" and "below," along with similar terms, designate relative vertical positions from the frame of reference shown in legend. The terms do not necessarily correspond to terrestrial notions of "above" and "below" or "up" and "down," however. Thus, a first feature may be identified herein as "above" or "on top of" a second feature even though the second feature appears to be below the first feature from a particular observer's point of view.

According to one or more embodiments, the second die 120 further includes a reflecting patch 150 formed from a portion of a metal layer thereof. Preferably, the reflecting patch 150 is formed as a portion of the outermost metal layer 125 of the build-up structure 124, i.e., the same layer that includes the electrode pads 128. The reflecting patch 150 may be formed from portions of other metal layers of the second die 120, though. In some embodiments, the reflecting patch 150 is exposed at the first surface of the second die 120. In this manner, the reflecting patch 150 is a planar conductive structure that is parallel to, vertically aligned with, and spaced apart from the antenna patch 130. Preferably, the reflecting patch 150 and the antenna patch 130 are directly face to face (i.e., with the first surfaces of the dies 110, 120 facing each other) with an air gap or dielectric material in the space between them, and with no layers of either the first die 110 or the second die 120 disposed between them. In some examples, though, the space between the two dies 110 and 120 is filled with a dielectric material to enhance mechanical properties. A distance 164 separates the antenna patch 130 from the reflecting patch 150, and such distance 164 may be defined by the height of the copper pillars or other vertical conductors 162. For example, copper pillars may be selected or constructed with a height that defines the distance 164 needed to establish desired reflection characteristics. Non-limiting values of the distance 164 are tens of microns, such as 50-60 microns for use with 100 GHz signals, for example. The distance 164 may be greater or less than the above-given range, as well.

Preferably, the reflecting patch 150 is grounded. In an example, the reflecting patch 150 has a thickness of at least 3 microns and a skin depth less than 0.3 microns above 100 GHz. Thus, the reflecting patch 150 behaves both as a reflector to signals emitted from the antenna patch 130 and as an electrostatic shield for circuitry within the second die 120 below the reflecting patch 150.

According to one or more embodiments, the device 100 further includes a parasitic patch 170. For example, a portion of a second layer 172 of the first die 110, such as a back-metallization layer on the second surface of the first die 110, defines the parasitic patch 170. As shown, the parasitic patch 170 is a planar conductive structure that is parallel to, vertically aligned with, and spaced apart from the antenna patch 130. In an example, a thickness of the first die 110 may be selected, or the first die 110 may be thinned, to establish a desired distance between the antenna patch 130 and the parasitic patch 170. Non-limiting values of the thickness of the first die 110 (and the distance between patches 130, 170) are between 150-250 microns, for example, although the thickness may be smaller or larger, as well. Although some embodiments do not require a parasitic patch 170, one should appreciate that the parasitic patch 170 can increase the bandwidth of signals transmitted by the antenna patch 130 and may thus have beneficial effects on performance.

In an example, the first die 110 also includes a conductive shield 170.1, which at least partially laterally surrounds the parasitic patch 170 and provides electrostatic shielding. A non-conductive gap is present between the outer perimeter of the parasitic patch 170 and the inner perimeter of the conductive shield 170.1. In some embodiments, the conductive shield 170.1 completely surrounds the perimeter of the parasitic patch 170. For example, the conductive shield 170.1 may be formed from a portion of the second metal layer 172 with additional metallization built up over that portion of the second metal layer 172. Alternatively, the conductive shield 170.1 may be a discrete structure that is attached to the second metal layer 172 or to the second surface of the first die 110. Preferably, the conductive shield 170.1 is grounded, e.g., electrically coupled through multiple TSVs 116 and through build-up structure 114 to respective electrode pads 118 of the first metal layer 132, which are electrically coupled to one or more ground reference planes within the second die 120.

According to one or more embodiments, the conductive shield 170.1 is taller than the parasitic patch 170 for providing a ground fence for lateral shielding. For example, the parasitic patch 170 has a height 174, and the conductive shield 170.1 has a height 176 that is greater than the height 174. According to one or more embodiments, the height 176 of the conductive shield 170.1 may be in a range of about 50 to 150 microns, although the height 176 may be smaller or larger, as well, depending on frequency of operation and design optimization.

Some embodiments may further benefit from a second parasitic patch 190, e.g., one that can even further extend the bandwidth of signals emitted by the antenna patch 130. In an example, the second parasitic patch 190 is formed by applying an insulating layer 180 over the second surface of the first die 110, over the second metal layer 172, and over the conductive shield 170.1, and then applying the second parasitic patch 190 as a portion of yet another metal layer on top of the insulating layer 180. The insulating layer 180 preferably has a low dielectric constant and low dielectric losses, and may be composed of a reinforced hydrocarbon/ceramic laminate or other material, for example. According to one or more embodiments, which are not intended to be limiting, the antenna patch 130 and the parasitic patches 170 and 190 are each approximately 3 microns thick.

As shown, the second parasitic patch 190 is a planar conductive structure that is parallel to, vertically aligned with, and spaced apart from the parasitic patch 170, which may also be referred to herein as the "first" parasitic patch 170. The insulating layer 180 has a thickness 182 that defines a distance between the first parasitic patch 170 and the second parasitic patch 190. Such thickness 182 is preferably controlled for establishing desired bandwidth effects.

In example operation, the circuit 126 in the second die 120 produces a high-frequency, low-power output signal, which passes through the interconnect 160 and into the first die 110, where it reaches the input terminal 140.1 of the amplifier 140. The amplifier 140 boosts the signal, e.g., by providing greater voltage and/or current, and the boosted signal travels from the output terminal 140.2 of the amplifier 140 to the driven patch 130, which radiates the signal vertically, both up and down. The downward-radiating signal encounters and reflects from the reflecting patch 150, reversing direction and extending upwardly through the first die 110. The reflected signal and the upwardly-radiating signal from the antenna patch 130 add together and advance toward the first and second parasitic patches 170 and 190, respectively, which create resonances that shape the bandwidth of the signal emitted from the top of the device 100.

It can thus be seen that the device 100 incorporates an AiP that begins with the reflecting patch 150 in the second die 120 and continues to the antenna patch 130 and the first parasitic patch 170 in the first die 110, further extending in some examples to the second parasitic patch 190 above the first parasitic patch 170. The device 100 can thus realize an AiP in a much shorter form factor than could be achieved with the prior approach. Also, the presence of the amplifier 140 in the first die 110 avoids power losses between dies, also avoiding the need for coaxial TSVs.

FIG. 2 is a top plan view of the device 100 according to one or more embodiments. Here, the insulating layer 180 and the second parasitic patch 190 have been removed to reveal the second metal layer 172 and the conductive shield 170.1. As shown, the first parasitic patch 170 is a square patch, and the conductive shield 170.1 is a region that completely surrounds the square patch. These shapes are merely examples, though, as other shapes may be used, such as circles, rectangles, other polygon shapes, or irregular shapes, which may be selected based on desired bandwidth and gain characteristics. In some examples, the conductive shield 170.1 is provided in separate portions, rather than as one continuous region. As further shown in FIG. 2, bond pads 128.1 are provided around the entire perimeter of the second die 120. This is merely an example, however, provided for purposes of illustration.

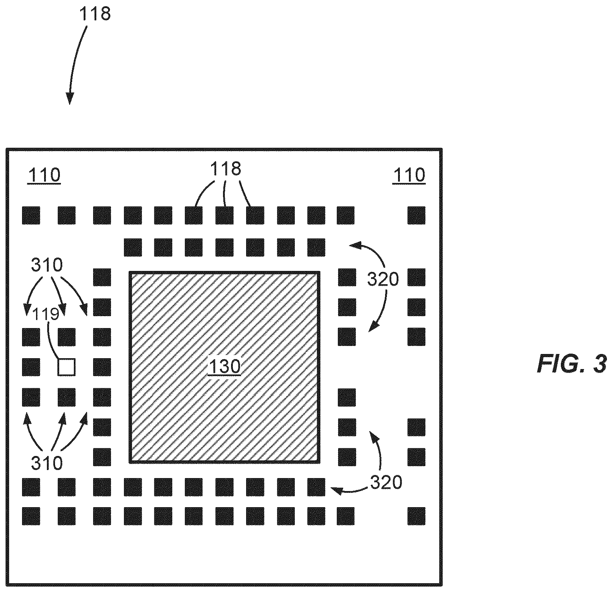

FIG. 3 is a bottom plan view of the first die 110 according to one or more embodiments. Several electrode pads 118 119 are visible. Electrode pads 118 are ground pads, and electrode pad 119 is a signal pad (only one signal pad is shown). Notably, multiple ground pads 310 of the ground pads 118 surround the signal pad 119, providing a degree of coaxial shielding around the signal pad 119. Also, multiple ground pads 320 of the ground pads 118 surround the antenna patch 130, providing a degree of coaxial shielding around the antenna patch 130. In an example, the depicted ground pads 310 and 320 are associated with and electrically coupled to respective TSVs 116 (FIG. 1) within the first die 110. Such TSVs extend through the substrate 112 of the first die 110 and are electrically coupled to the conductive shield 170.1 at respective locations. Thus, for example, the TSVs provide coaxial shielding above the signal pad 119 and around the region above the antenna patch 130 within the substrate 112 of the first die 110.

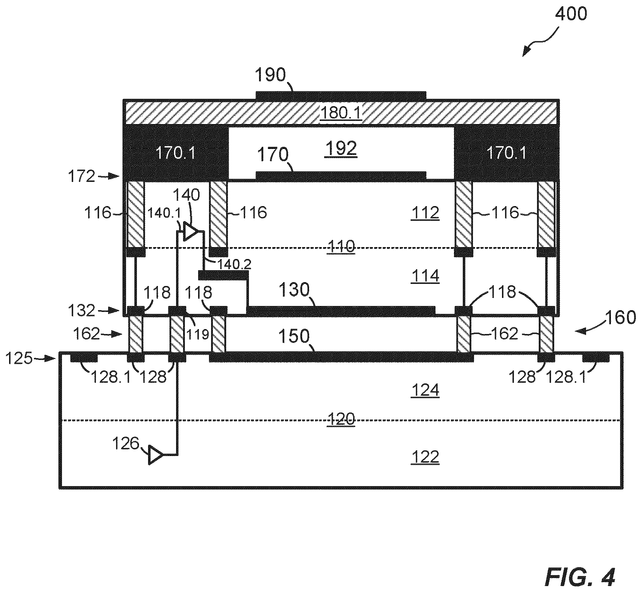

FIG. 4 is a cross-sectional view of an alternative electronic device 400 according to one or more embodiments. Here, the device 400 differs from the device 100 (FIG. 1) in that the insulating layer 180 is provided in the form of a sheet 180.1 of insulating material, and the insulating sheet 180.1, inner sidewalls of the conductive shield 170.1, the second surface of the first die 110, and the second metal layer 172 define an air gap 192. Air provides extremely low dielectric losses and may be preferred in embodiments that can benefit from lower dielectric losses than those provided by the insulating layer 180 at intended design frequencies, e.g., 100 GHz and above. Other features of the device 400 are substantially similar to those described above in connection with the device 100.

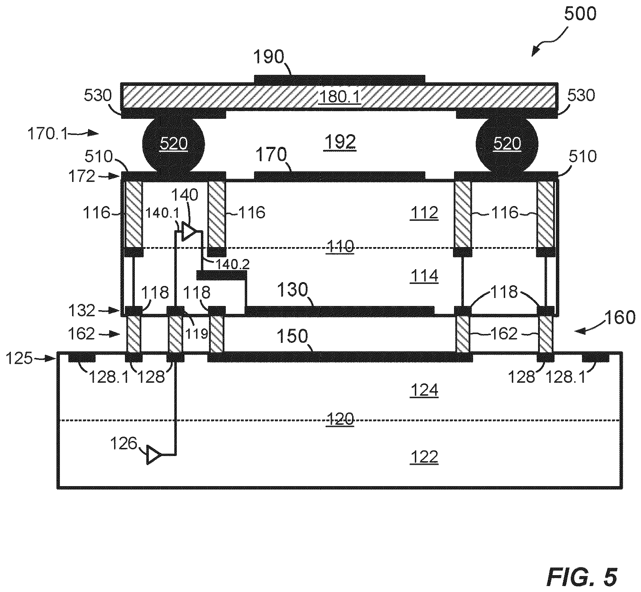

FIG. 5 is a cross-sectional view of another alternative electronic device 500 according to one or more embodiments. The device 500 differs from the device 400 of FIG. 4 in that the conductive shield 170.1 is realized at least in part using solder balls 520. For example, contact pads 510 may be formed from portions of the second metal layer 172, e.g., in the same pattern as the conductive shield 170.1 in the embodiments of FIGS. 1 and 4. In this embodiment, however, the contact pads 510 may have the same height as the parasitic patch 170, with the overall height of the conductive shield 170.1 defined primarily by the height of the solder balls 520. Also, the insulating sheet 180.1 may have a metallization layer on its bottom surface that provides contact pads 530 for attaching to the solder balls 520. In an alternate embodiment, conductive pillars may be used in lieu of solder balls 520. The device 500 also has an air gap 192. Other features of the device 500 are substantially similar to those described above in connection with the device 100.

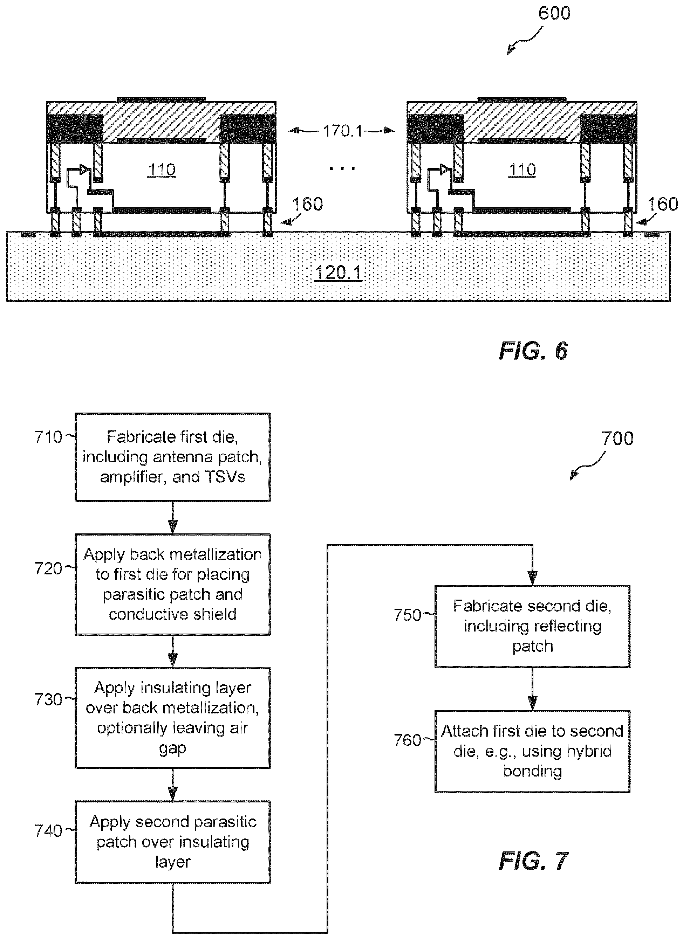

FIG. 6 is a cross-sectional view of a device 600 that includes multiple antennas, according to one or more embodiments. For example, the device 600 may be suitable for use as an antenna array. As shown, the device 600 includes a mother die 120.1 to which multiple daughter dies 110 are attached through respective interconnects 160. The mother die 120.1 is an expanded version of the above-described second die 120, which is adapted to attach to multiple first dies 110. Each of the first dies 110 may be identical to the first die 110 shown in any of FIGS. 1, 4, and/or 5, for example. In the FIG. 6 embodiment, the conductive shields 170.1 play a particularly beneficial role in isolating each antenna from its neighbors. Although FIG. 6 shows only two daughter dies 110, device 600 may include more daughter dies that are arranged in a line or in an array that includes multiple rows and columns of daughter dies.

FIG. 7 shows an example method 700 of making an electronic device, such as any of the devices 100, 400, and 500 described above, according to certain embodiments. The method 700 is typically performed, for example, by one or more semiconductor fabrication facilities, one or more preassembly fabrication facilities, and/or one or more OSATs (outsourced semiconductor assembly and test facilities). The method 700 is presented as a general overview rather than as a strict procedure. For example, some embodiments may omit certain steps. Also, some embodiments may perform the illustrated steps in different orders from the one illustrated. Certain steps may be performed simultaneously. The method 700 should thus be regarded as illustrative rather than limiting.

At step 710, the first die 110 is fabricated. Such fabrication includes both FEOL and BEOL processing and creates patterned features for realizing the antenna patch 130 and the amplifier 140, as well as the TSVs 116, electrode pads 118, 119, and other structures shown within the first die 110.

At step 720, a patterned back metallization layer (e.g., the second metal layer 172) is applied to the first die 110 for constructing the parasitic patch 170 and the lower portion of the conductive shield 170.1. The additional height of the conductive shield 170.1 may be achieved by building up additional conductive material on the lower portion of the conductive shield 170.1 and/or by attaching a separate conductive structure to the lower portion of the conductive shield 170.1. Multiple sub-steps may be performed for establishing different heights of the parasitic patch 170 and the conductive shield 170.1.

At step 730, an insulating layer 180 is applied over the patterned back metallization layer. According to one or more embodiments, an air gap 192 is provided between the back metallization layer and the insulating layer, which may be provided in such embodiments as an insulating sheet 180.1.

At step 740, a second parasitic patch 190 is applied over the insulating layer 180 or 180.1. For example, the second parasitic patch 190 is applied as a patterned metallization layer on or above the insulating layer 180 or 180.1.

At step 750, the second die 120 is fabricated. Such fabrication includes both FEOL and BEOL processing and creates patterned features for realizing the reflecting patch 150 as well as electrode pads 128 and other structures shown within the second die 120. For supporting antenna arrays, a second die 120.1 may be fabricated, which includes multiple reflecting patches 150 and multiple sets of electrode pads 128, e.g., one reflecting patch 150 and one set of electrode pads 120 for each first die 110 to be attached later.

At step 760, the first die 110 is attached to the second die 120 with interconnect 160, e.g., using hybrid bonding with copper pillars or other vertical conductors 162. In the case of antenna arrays, multiple first dies 110 are attached to a second die 120.1 with multiple interconnects 160 in a similar manner. One should appreciate that the second die 120 (or 120.1) may be fabricated at any time prior to step 760, including prior to fabrication of the first die 110 (step 710).

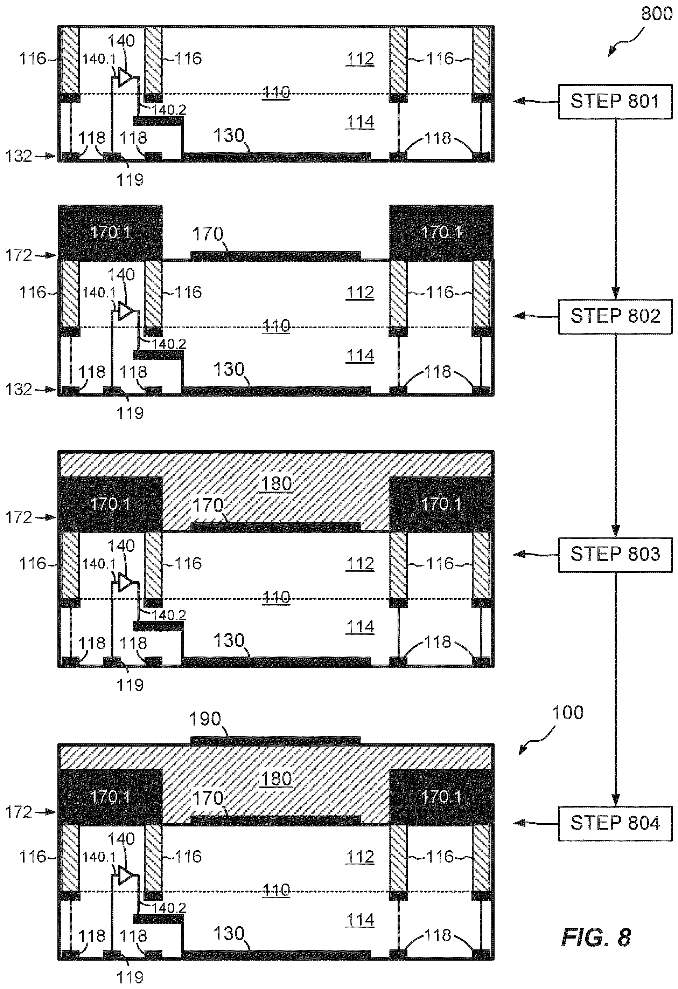

FIGS. 8-10 show example pictorial views of process steps for making the devices 100, 400, and 500, according to certain embodiments. Starting with FIG. 8, an example process 800 is shown of making the device 100 of FIG. 1.

At step 801 of FIG. 8, the first die 110 is fabricated to provide the depicted features, e.g., as described in connection with step 710 of FIG. 7. Such fabrication may be performed by a semiconductor fabrication facility, for example.

At step 802, a patterned back metallization layer is applied to the first die 110 to form the second metal layer 172 (FIG. 1), e.g., as described in connection with step 720 of FIG. 7. Additional processing steps are performed to build up or attach the conductive shield 170.1. In an example, different heights are established, including a first height 174 of the parasitic patch 170 and a second height 176 of the conductive shield 170.1 (FIG. 1). Preferably, the second metal layer 172 has a height of zero (no metal) in the area between the parasitic patch 170 and the conductive shield 170.1 in order to create a non-conductive gap between the parasitic patch 170 and the conductive shield 170.1. According to one approach, the second metal layer 172 is laid down in two sub-steps: a first sub-step in which metal is deposited to height 174 in the regions of both the parasitic patch 170 and the conductive shield 170.1, a second sub-step includes patterning the metal layer 172 to produce a gap between the patch 170 and shield 170.1, and a third sub-step in which metal is added to build up the conductive shield 170.1 to the height 176. These are merely examples provided for illustration.

At step 803, an insulating layer 180 is applied over the second metal layer 172, e.g., as described in connection with step 730 of FIG. 7. The insulating layer 180 may be applied by laminating, sputtering, skin coating, or screen printing, for example.

At step 804, the second parasitic patch 190 is applied over the insulating layer 190, e.g., as described in connection with step 740 of FIG. 7. In an example, steps 802, 803, and 804 are performed by an OSAT or a preassembly fabrication facility.

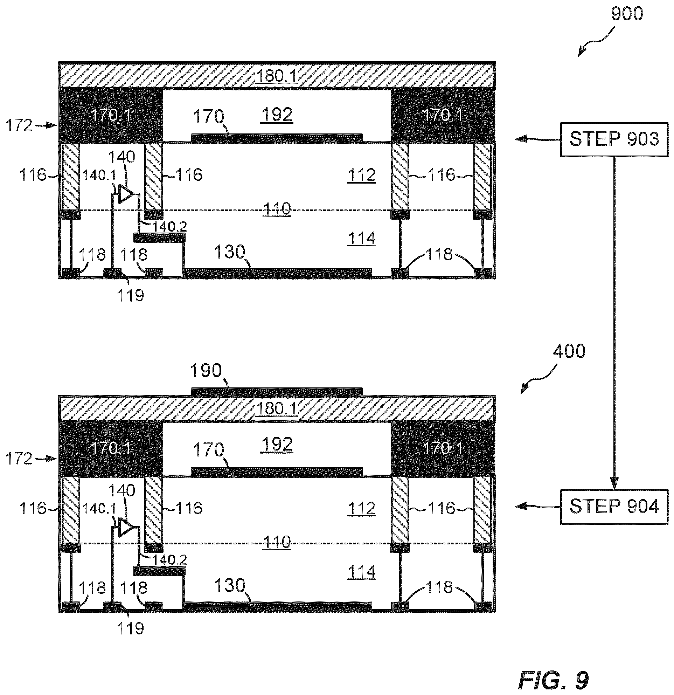

FIG. 9 shows an example process 900 of making the device 400 of FIG. 4. Two initial steps (not shown) are identical to steps 801 and 802 (FIG. 8) and are not repeated here. At step 903, an insulating layer 180.1 is applied over the conductive shield 170.1. For example, the layer 180.1 may be applied as a laminated sheet while the first die 110 is still part of a wafer. The sheet 180.1 has sufficient stiffness that it permits formation of the air gap 192. At step 904, the second parasitic patch 190 is applied. The wafer may then be singulated to form individual dies 110.

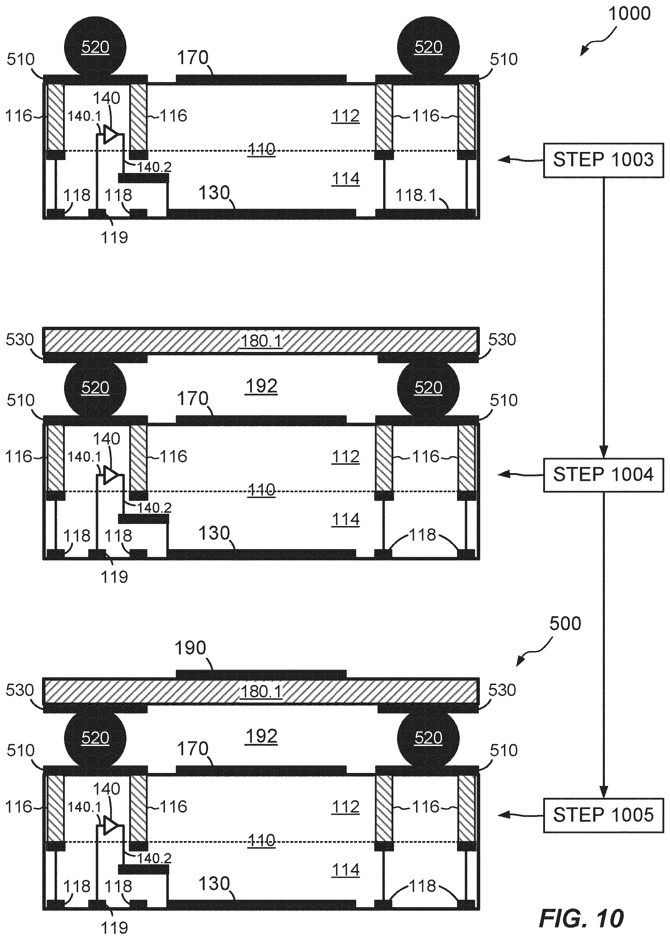

FIG. 10 shows an example process 1000 of making the device 500 of FIG. 5. The first two steps (not shown) are identical to steps 801 and 802 (FIG. 8), except that the conductive shield 170.1 is not built up on or attached to the conductive layer 172. At step 1003, solder balls 520 are deposited on top of contact pads 510. In an alternate embodiment, conductive pillars may be used in lieu of solder balls 520. At step 1004, an insulating sheet 180.1 is applied over the solder balls 520, such that the contact pads 530 align with the solder balls 520. The solder balls 520 may be reflowed at this time, or at a later time, to establish firm connections. At step 1005, the second parasitic patch 190 is deposited upon the insulating sheet 180.1.

An improved technique has been described of providing an AiP solution. The technique includes a first die 110, a second die 120, and an interconnect 160 that electrically couples the first die 110 with the second die 120. The first die 110 includes an antenna patch 130, an amplifier 140 that drives the antenna patch 130, and a parasitic patch 170, and the second die includes a reflecting patch 150. The improved technique provides the amplifier 140 in the same die 110 as the antenna patch 130, thus avoiding losses normally incurred by transmitting high-frequency signals between dies. In addition, the technique leverages the geometries of the first die 110, the second die 120, and the interconnect 160 to establish desired spacing among the antenna patch 130, the reflecting patch 150, and the parasitic patch 170, and to place antenna structures farther down in the vertical stack 102 than could be achieved in the previous design, enabling the antenna to be realized in a shorter form factor.

Certain embodiments are directed to an electronic device. The device includes a first die having a first metal layer that defines an antenna patch, a second metal layer that defines a parasitic patch above and vertically aligned with the antenna patch, and an amplifier having an output terminal electrically coupled to the antenna patch. The electronic device further includes a second die having a metal layer that defines a reflecting patch and an interconnect that joins the first die with the second die in a vertical stack with the first die above the second die such that the antenna patch is spaced apart from, parallel to, and vertically aligned with the reflecting patch.

According to one or more further embodiments, the amplifier further has an input terminal electrically coupled through the interconnect to the second die.

According to one or more further embodiments, the antenna patch and the reflecting patch are face to face with no layers of the first die or the second die disposed between the antenna patch and the reflecting patch.

According to one or more further embodiments, the interconnect includes a plurality of copper pillars arranged to electrically couple the first die to the second die, and the plurality of copper pillars has a height that defines a spacing between the antenna patch and the reflecting patch.

According to one or more further embodiments, the electronic device further includes a conductive shield that at least partially laterally surrounds the parasitic patch.

According to one or more further embodiments, the conductive shield is electrically coupled to the interconnect through multiple TSVs (through substrate vias).

According to one or more further embodiments, the conductive shield has a height that exceeds a height of the parasitic patch.

According to one or more further embodiments, the electronic device further includes an insulating layer disposed above the second metal layer and a second parasitic patch formed upon the insulating layer.

According to one or more further embodiments, the second metal layer and the insulating layer define an air gap between the parasitic patch and the insulating layer.

According to one or more further embodiments, the second die is a mother die and the first die is one of multiple daughter dies attached through respective interconnects to the mother die.

Other embodiments are directed to a semiconductor die. The semiconductor die includes a first metal layer that defines an antenna patch on a first surface of the die, a second metal layer that defines a parasitic patch on a second, opposite surface of the die, the parasitic patch vertically aligned with and parallel to the antenna patch, a conductive shield that at least partially laterally surrounds the parasitic patch, and an amplifier having an output terminal electrically coupled to the antenna patch.

According to one or more further embodiments, the semiconductor die further includes a semiconductor substrate between the first metal layer and the second metal layer. The conductive shield is electrically coupled through the semiconductor substrate to a set of electrode pads formed in the first metal layer.

According to one or more further embodiments, the conductive shield is electrically coupled through the semiconductor substrate using a plurality of TSVs (through substrate vias), each TSV of the plurality of TSVs electrically coupled between the conductive shield and a respective electrode pad of the set of electrode pads.

According to one or more further embodiments, the conductive shield has a height that exceeds a height of the parasitic patch.

According to one or more further embodiments, the semiconductor die further includes an insulating layer disposed above the second metal layer and a second parasitic patch formed upon the insulating layer.

According to one or more further embodiments, the second metal layer and the insulating layer define an air gap between the parasitic patch and the insulating layer.

Additional embodiments are directed to an electronic device. The electronic device includes a first die having a metal layer that defines an antenna patch, a second die having a metal layer that defines a reflecting patch, and an interconnect that joins the first die with the second die in a vertical stack such that the antenna patch is spaced apart from, parallel to, and vertically aligned with the reflecting patch.

According to one or more further embodiments, the first die includes an amplifier having an input terminal electrically coupled through the interconnect to the second die and an output terminal electrically coupled to the antenna patch.

According to one or more further embodiments, the antenna patch and the reflecting patch are face to face with no layers of the first die or the second die disposed between the antenna patch and the reflecting patch.

According to one or more further embodiments, the interconnect includes a plurality of copper pillars arranged to electrically couple the first die to the second die. The plurality of copper pillars has a height that defines a spacing between the antenna patch and the reflecting patch.

Having described certain embodiments, numerous alternative embodiments or variations can be made. For example, although embodiments have been described that include a first die 110 and a second die 120, further embodiments may be constructed that include greater than two dies, e.g., in more complex system-in-package solutions. Also, embodiments may be constructed that omit the second die 120, such that an antenna can be provided without a reflecting patch 150, or with a reflecting patch provided in a structure other than a die, such as a printed circuit board, a metal housing, or a shield. Further, embodiments can be constructed that provide no second parasitic patch 190, and/or that provide no first parasitic patch 170. Other embodiments may be constructed that include greater than two parasitic patches.

Further, although features have been shown and described with reference to particular embodiments hereof, such features may be included and hereby are included in any of the disclosed embodiments and their variants. Thus, it is understood that features disclosed in connection with any embodiment are included in any other embodiment.

As used throughout this document, the words *"comprising," "including," "containing,"* and *"having"* are intended to set forth certain items, steps, elements, or aspects of something in an open-ended fashion. Also, as used herein and unless a specific statement is made to the contrary, the word *"set"* means one or more of something. This is the case regardless of whether the phrase *"set of'* is followed by a singular or plural object and regardless of whether it is conjugated with a singular or plural verb. Also, a *"set of"* elements can describe fewer than all elements present. Thus, there may be additional elements of the same kind that are not part of the set. Further, ordinal expressions, such as *"first," "second," "third,"* and so on, may be used as adjectives herein for identification purposes. Unless specifically indicated, these ordinal expressions are not intended to imply any ordering or sequence. Thus, for example, a *"second"* event may take place before or after a *"first* event," or even if no first event ever occurs. In addition, an identification herein of a particular element, feature, or act as being a *"first"* such element, feature, or act should not be construed as requiring that there must also be a *"second"* or other such element, feature or act. Rather, the *"first"* item may be the only one. Also, and unless specifically stated to the contrary, *"based on"* is intended to be nonexclusive. Thus, *"based on"* should be interpreted as meaning *"based at least in part on"* unless specifically indicated otherwise. Further, although the term *"user"* as used herein may refer to a human being, the term is also intended to cover non-human entities, such as robots, bots, and other computer-implemented programs and technologies. Although certain embodiments are disclosed herein, it is understood that these are provided by way of example only and should not be construed as limiting.

Also, the foregoing description refers to elements or nodes or features being *"connected"* or *"coupled"* together. As used herein, unless expressly stated otherwise, *"connected"* means that one element is directly joined to (or directly communicates with) another element, and not necessarily mechanically. Likewise, unless expressly stated otherwise, *"coupled"* means that one element is directly or indirectly joined to (or directly or indirectly communicates with, electrically or otherwise) another element, and not necessarily mechanically. Thus, although the schematics and component features shown in the figures depict one exemplary arrangement of elements, additional intervening elements, devices, features, or components may be present in one or more other embodiments of the depicted subject matter.

Those skilled in the art will therefore understand that various changes in form and detail may be made to the embodiments disclosed herein without departing from the scope of the following claims.

## Claims

1. An electronic device, comprising:
a first die having a metal layer that defines an antenna patch;
a second die having a metal layer that defines a reflecting patch; and
an interconnect that joins the first die with the second die in a vertical stack such that the antenna patch is spaced apart from, parallel to, and vertically aligned with the reflecting patch.

2. The electronic device of claim 1, wherein the first die includes an amplifier having an input terminal electrically coupled through the interconnect to the second die and an output terminal electrically coupled to the antenna patch.

3. The electronic device of claim 1 or 2, wherein the antenna patch and the reflecting patch are face to face with no layers of the first die or the second die disposed between the antenna patch and the reflecting patch.

4. The electronic device of any of claims 1 to 3, wherein the interconnect includes a plurality of copper pillars arranged to electrically couple the first die to the second die, and wherein the plurality of copper pillars has a height that defines a spacing between the antenna patch and the reflecting patch.

5. An electronic device as claimed in claim 1, where:
the a first die has a second metal layer that defines a parasitic patch above and vertically aligned with the antenna patch, and an amplifier having an output terminal electrically coupled to the antenna patch;
a second die having a metal layer that defines a reflecting patch; and
an interconnect that joins the first die with the second die in a vertical stack with the first die above the second die such that the antenna patch is spaced apart from, parallel to, and vertically aligned with the reflecting patch.

6. The electronic device of claim 5, wherein the amplifier further has an input terminal electrically coupled through the interconnect to the second die.

7. The electronic device of claim 5 or 6, wherein the antenna patch and the reflecting patch are face to face with no layers of the first die or the second die disposed between the antenna patch and the reflecting patch.

8. The electronic device of any of claims 5 to 7, wherein the interconnect includes a plurality of copper pillars arranged to electrically couple the first die to the second die, and wherein the plurality of copper pillars has a height that defines a spacing between the antenna patch and the reflecting patch.

9. The electronic device of any of claims 5 to8, further comprising a conductive shield that at least partially laterally surrounds the parasitic patch.

10. The electronic device of claim 9, wherein the conductive shield is electrically coupled to the interconnect through multiple TSVs (through substrate vias).

11. The electronic device of claim 9 or 10, wherein the conductive shield has a height that exceeds a height of the parasitic patch.

12. The electronic device of claim 10, further comprising:
an insulating layer disposed above the second metal layer; and
a second parasitic patch formed upon the insulating layer.

13. The electronic device of claim 12, wherein the second metal layer and the insulating layer define an air gap between the parasitic patch and the insulating layer.

14. The electronic device of any of claims 5 to 13, wherein the second die is a mother die and the first die is one of multiple daughter dies attached through respective interconnects to the mother die.
